# EUROPEAN PATENT APPLICATION

(11) **EP 2 493 277 A2**
(43) Date of publication of application: **29.08.2012**
(21) Application number: 11179843.5
(22) Date of filing: 02.09.2011
(51) Int. Cl.: H05K 7/20

(54) **An improvement in the cooling system for telecommunication shelters**

(30) Priority: 22.02.2011 IN LL04932011
(71) Applicant: Stulz-Chspl (India) PVT, Ltd., 400 016 Mumbai (IN); Balakrishnan, Rajesh, 400 016 Mumbai (IN)
(72) Inventor: Balakrishnan, Rajesh, 400 016 Mumbai (IN)
(74) Representative: Hannke, Christian

(57) **Abstract**

Invention relates to an improved cooling system for telecommunication shelters. The cooling system comprises a frame structure provided with a first air filter at bottom for out side air blowing into the space to be cooled. A pivoted indoor fan with inlet enable to turn through 0 to 180° mounted above the said first air filter. A slanted evaporator coil of refrigerator system mounted above the said indoor fan. A second air filter in horizontal fixed the said frame above the said evaporator coil. A chute means fixed the said second filter for directing inside air to filter. A condenser coil of refrigerator system, open to outside air and insulated to inside space, fixed above the said second filter with a out door fan on top for cooling of condenser. The arrangement is such that the suction of the said indoor fan inlet, as per mode of operation, either to face first air filter to blow outside air or towards the second filter to blow inside air into the space to be cooled.

## Description

The following specification particularly describes the invention and the manner in which it is to be performed. The Invention relates to an improvement in the cooling system for telecommunication units, more particularly providing improved air conditioner system for cooling of telecommunication unitswith non clogging filter and improvement of free cooling mode in the shelters. The invention improves the performance of the unit in Free Cooling Mode and reduces operating expenditure and maintenance cost.

### Prior art

The current systems available in the telecom market uses an inbuilt free-cooling system in the air conditioner and by the use of a damper and actuator (40) the air path is changed to switch between the modes i:e air-conditioning and free cooling. Common single filter provided to pass out side air and inside air into the space to be cooled. The clogging filter affects the efficiency of evaporator and increases power consumption in Air-conditioning mode and also the reduced air volumes in free cooling mode makes this mode not an efficient solution for the product.

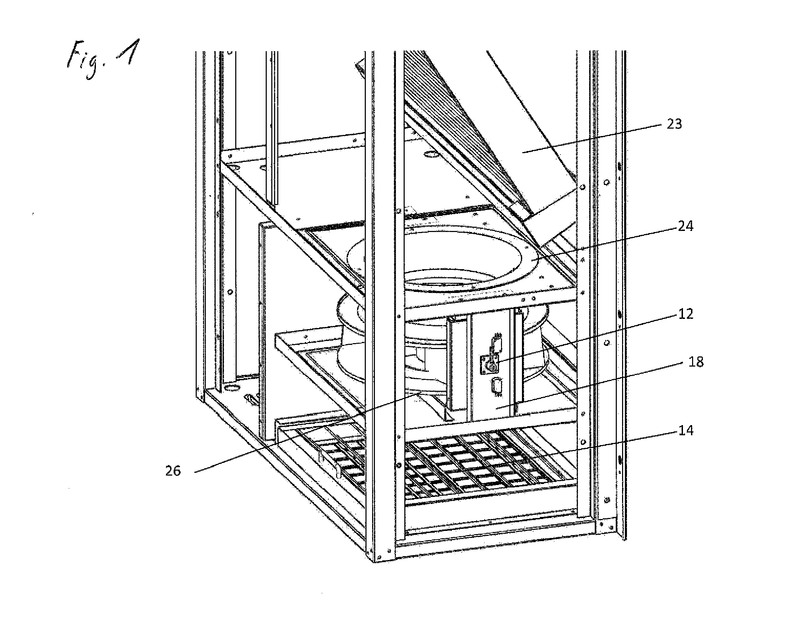

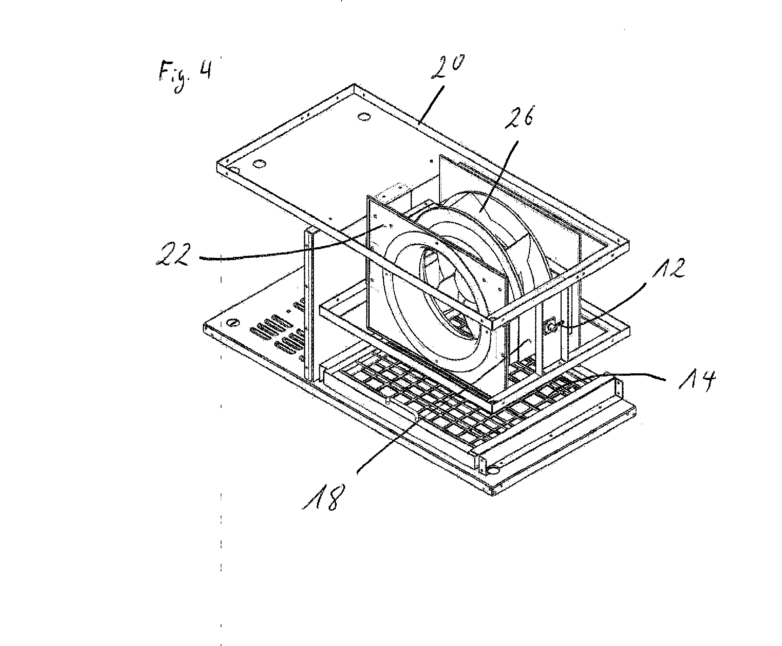

The figure 1 to 4 illustrates the features of cooling system according to prior art.

The prior art is having following draw backs:-
1) it uses a damper to guide the air direction inside the unit to enable change in modes which causes a big pressure difference in the air stream and hence consumes more energy on the installed evaporator fan.
2) it uses louvers or slits for outside air to enter and this causes a lot of loss of efficiency due to the pressure drop exerted by the said slits. The efficiency of the said slit is approx 35% as compared to a free open perforation.
3) It uses a common filter for air cleaning which is easily clogged when outside air is passed through the unit.
4) The clogging of the filter causes loss of airflow in free cooling mode and reduces air performances when running in air-conditioning mode and this causes a serious loss of efficiency for the unit.
5) The outside air is passed through the evaporator coil irrespective of the mode that causes loss of cooling capacity of the coil when in air-conditioning mode as the filter has limited capacity in terms of efficiency.
6) The damper arrangement is not leak proof and is prone to leak and increases the tempreture differences between modes.
7) Overall system operation and unit becomes inefficient as dirt/dust/debris present in the air settles down inside the complete unit which makes cleaning not possible and consequently efficiency is lost which leads to high maintenance and performance cost.
8) The power consumption of theprior art is high as the maintenance is not done frequently which results into high operating expenses.
9) It is not easy to approach the unit as all the access to the unit is made for rear side only.
10) To improve the efficiency in prior art, many times these sites are installing additional free cooling boxes with fan and filters as the inbuilt free cooling system with the existing unit does not use the free cooling unit optimally.

### Object of invention

The objective of this invention to provide a cooling system especially to telecommunication units that providing air conditioner with less energy consumption by removing dampers.

Another objective of this invention is to provide cooling system comprises an efficient air conditioner without slits/louvers.

Yet another objective of this invention is to provide cooling system by air conditioning and or Free Cooling using separate filters for free cooling mode and also for air conditioning mode and not allowing out side air to pass through the evaporator coil in any mode.

In nutshell, over all objective of this invention is to use maximum Free Cooling to save on energy usage and improve operating expenses and maintenance cost. Yet another objective of this invention is to use a simple mechanism where the evaporation is possible in different directional operation making the unit a stand alone combination unit uses an air-conditioning system and a free cooling unit in complete isolation while the evaporator fan remains common for both units making the cooling system according to this invention a cost effective and extremely efficient to operate.

### Statement of invention

The invention provides an improved cooling system for telecommunication units comprising a frame structure provided with a first air filter at the bottom of the frame structure for out side air blowing into the space to be cooled; a pivoted or pivotable indoor fan which enable the inlet of the fan to turn through 0 to 180° wherein the indoor fan is preferably mounted above the said first air filter; a slanted evaporator coil of refrigerator system mounted above the said indoor fan; a second air filter in horizontally fixed in or with respect to the said frame above the said evaporator coil; a chute means preferably fixed to the said second filter for directing inside air to the (especially second) filter; a condenser device, especially a condenser coil of refrigerator system, open to outside air and insulated to inside space, fixed above the said second filter with a out door fan on top for cooling of the condenser.

According to the invention the arrangement is such that the suction of the said indoor fan inlet, (especially as per mode of operation), either faces the first air filter to blow outside air or towards the second filter to blow inside air into the space to be cooled.

Preferably the said actuator means is an electronically operated DC Actuator motor driving a rotating arrangement, especially a well engineered rotating arrangement.

### Drawings

To understand the invention constructional feature of invention reference is made to accompanying drawings where in:-
Figure 1 shows the part front view of cooling system according to invention showing indoor fan facing evaporator (Air-conditioning mode - Air passes through evaporator)
Figure 2 shows part of front view of cooling system according to invention showing partially rotated indoor fan in the panel mounting; (Parts of Rotating Fan)
Figure 3 shows perspective of fan fixed in the panel mounting; (Rotating Panel)
Figure 4 shows perspective of fan fixed is rotatable o° to 180° in the panel mounting;
Figure 5 shows side view of cooling system with cover removed showing Air-conditioning mode;
Figure 6 shows side view of cooling system with cover removed showing free cooling mode operation;
Figure 7 shows perspective view of panel mounting in which frame mounting of indoor fan is rotateably assembled;

### Description

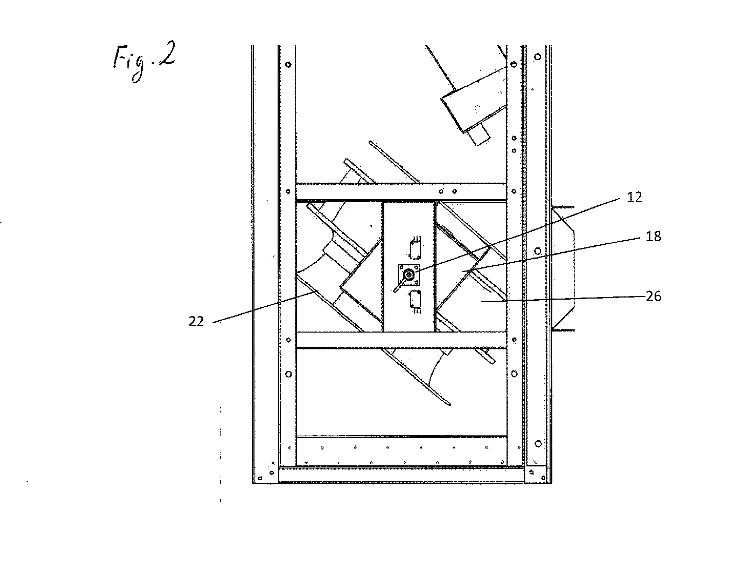

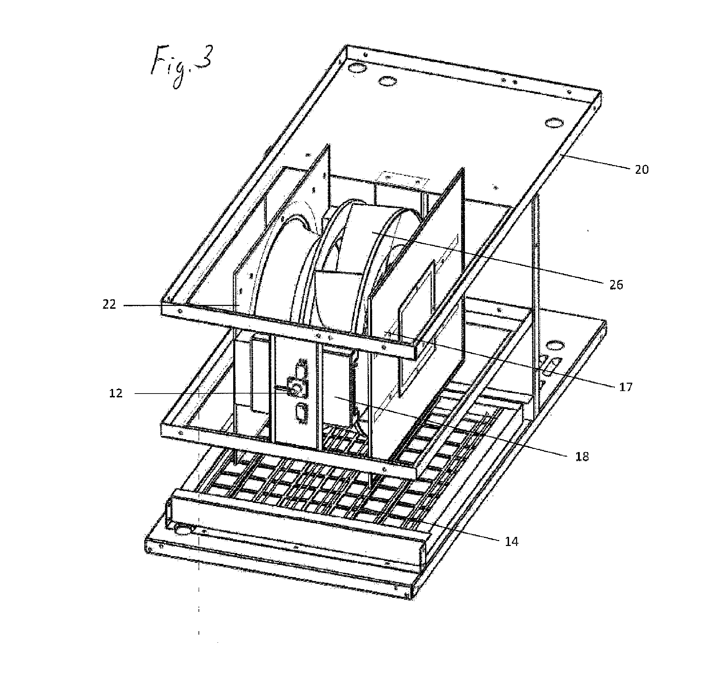

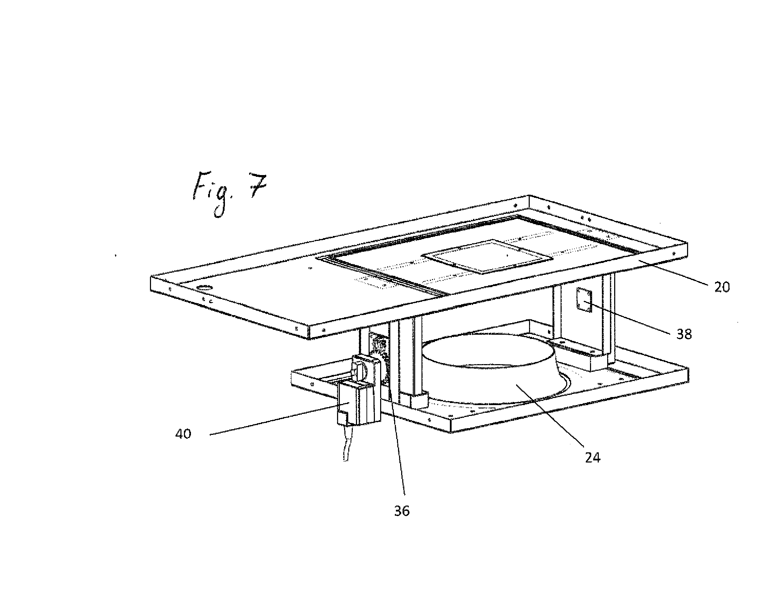

Referring figures 1 to 7 all cooling system 10) comprises a metallic frame structure 12 which is a rack type structure. In the bottom of the said frame an air filter 14 is provided for taking out side air in side the cooling space. An indoor fan 16 is fixed above the said air filter 14. The said indoor fan, shown in figure 7, is mounted in a fan mounting body 18 having top with cone shaped circular opening member and bottom is closed member and sides are open. The said top and bottom member are joined by a pair of pivots and especially strip members opposite and distant. The said fan mounting is preferably hingeably fixed in panel mounting to a vertical strip attached to the top member of said panel mounting 20. The vertical strip support the bearing means to hold the said fan mounting body tilt-ably. The said indoor fan is tilt-able through 0° to 180° fig 3. The said indoor fan figure 7 while assembling in the panel mounting 20, the suction inlet 22 is made to face the inlet cone 24 of panel mounting (fig.1). The outlet 26 is along blower blade direction. The fan may be worked with facing inlet cone to wards air filter or facing upward, still the out is from side (90° to inlet). The figures 2 to 4 illustrate the features of indoor fan mounting in the panel mounting 20. The panel mounting is fixed in the frame structure after indoor fan fitting therein.

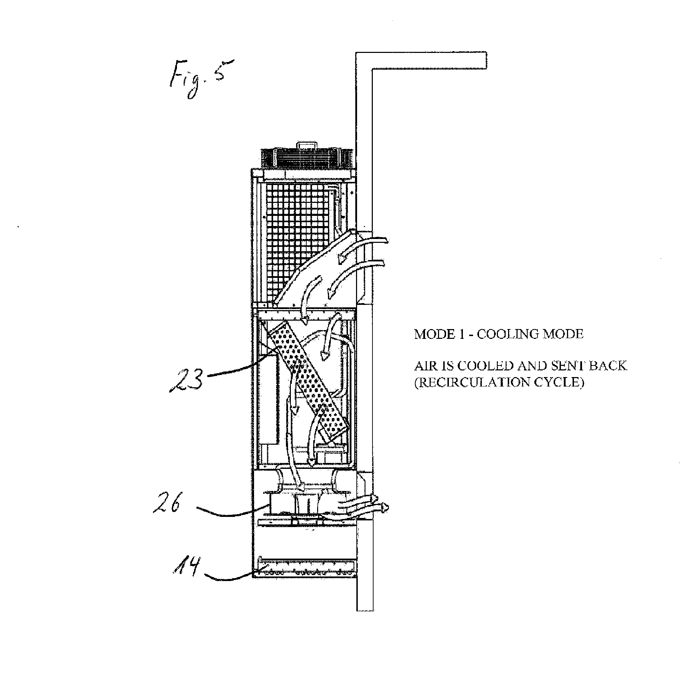

An inclined evaporator 28 of refrigerator system is fixed above the fan. Above the evaporator a second air filter 30 is provided to pass internal air to evaporator 28 for cooling. The said indoor fan facing upwardly circulates air from internal space to second filter then to evaporator 28 to back space. Thus is working in the air conditioning mode (Fig 5).

A condenser 32 is provided above the evaporator and said is isolated from internal space. An out door fan 34 fixed on top for air circulation over the condenser.

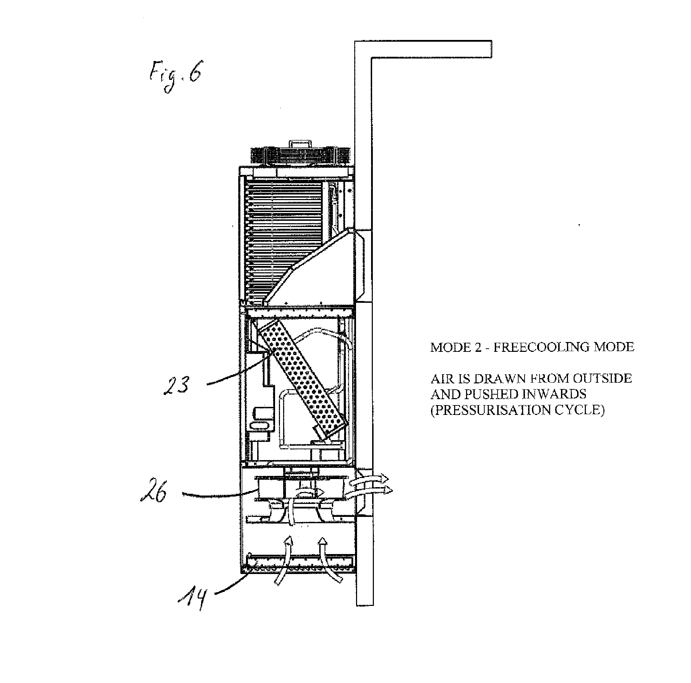

Internal air is directed to the said second filter through a chute means. The out door air is blown into the internal space by turning the said indoor fan to face inlet cone towards first air filter. Out door air is sucked by the said fan through the said first filter and then blown into circulated into the internal space. The figure 6 shows the path of air during free cooling mode. The electrical control circuit panel is provided in the said frame structure in between the said second filter 30 and condenser 32.

The frame structure is provided external covers totally enclose unit as shown in figure 1 to avoid external dust entering into the unit. In prior art the cooling unit can not be closed with covers as only single common air filter. In figures 5 and 6 partial opening are provided outside to pass through the said single filter.

Preferably the improved cooling system provides dual path for air movement. These dual paths are preferably at least partially and very preferably essentially completely separated from each other.

As described working of cooling system either free cooling mode or air condition mode, it is required to change axis of indoor fan through 180° to align inlet cone of fan mounting to face first filter at bottom or align inlet cone to face second filter above the evaporator respectively. Axis changing mechanism coupled to hinge pin of pivot 38 is a electrically operated actuator 40 and maintenance free with well known mechanism having auto selection or controller to set the said indoor fan 0° or 180° for selecting mode of operation either free cooling mode or air conditioning mode.

The said electrical mechanism is a DC Actuator 40 motor operating a gear mechanism 36 with two position stopper switch to rotate indoor fan through 0° to 180°.

The axis changing means is mechanically operated mechanism with lever and gear combination means to set the said indoor fan 0° or 180° for selecting mode of operation either free cooling mode or air conditioning mode .

Referring to figure 3 panel mounting 20 having pair of vertical strip member parallel at distant. A fan mounting 18, also having pair of vertical strip members parallel and distant and closely fitting between said vertical members of said panel mounting, hinge ably fitted therein to the pivot 38 external surface of one of the said vertical member of said panel member provided with a pair of meshing gears. One of the said gears is driven gear attached to the motion transfer shaft fitted to the said vertical strip of the fan mounting through a hole bearing in the said vertical strip of panel mounting. The gear wheel is provided with driving shaft same be coupled to an actuating motor electronically operated or same may be rotated by a crank handle.

The figures 5, 6 and 7 clearly illustrates arrangement and working.

### Advantages invention

1) There is no damper unit thus eliminating any kind of air pressure drops which consumes higher energy.
2) There are no slits or perforations required for the said unit and that improves efficiency of the unit in general.
3) There are 2 numbers of filters which are physically isolated. This isolation eliminates efficiency losses. The filters are placed at different locations inside the unit and are independent of each other. The dependency is eliminated as the modes of operation - air - condition mode or cooling-free mode works independently.
4) The clogging of the free cooling filter does not affect the efficiency of the unit when running in cooling mode and vice versa. Hence the units are not dependant to each other
5) Outside air does not pass through the evaporator coil and hence the maintenance of the evaporator to remove debris/dust which accumulates when free cooling is active in the prior art is completely eliminated.
6) There is no damper in the unit hence leakages are eliminated.
7) Service and maintenance is easy as the unit is isolated from and efficiency is higher as compared to its prior art.
8) The filters and the unit can be serviced from the rear without any hindrances as all components are directly visible.
9) The different filters inside improve the unit performance as in cooling mode the generation of dust is negligible and hence a lower grade filter can be used whereas in the free cooling section a filter of higher grade and washable type will be used to improve air cleaning and also avoid ingress of dust inside the room.
10) Due to changing axis mechanism - the air conditioning mode and free cooling mode becomes two independent units combined in single chassis.
11) Improved cooling mechanism provides two air paths in single unit which offers high efficiency due to least resistance in the air movement inside unit.
12) Improved cooling mechanism provides two distinct mode of operation;
13) Improved cooling mechanism provides complete automated plug and use system with least external interference.

Finally, while the invention has been described by way of example and in terms of the preferred embodiment, it is to be understood that the invention is not limited to the disclosed embodiment. On the contrary, it is intended to cover various modifications and similar arrangements as would be apparent to those skilled in the art. Therefore, the scope of the appended claims should be accorded the broadest interpretation so as to encompass all such modifications and similar arrangements.

## Claims

1. An Improved cooling system (10) for telecommunication units comprising:
a frame structure (12);
a first air filter (14) provided at bottom of said frame structure (12) for blowing of out side air into the space to be cooled;
a pivotable indoor assembly fan (16) with an actuator means (40) mounted above the said first air filter (14), which enable the inlet of the fan (16) to turn through 0° to 180° above said first air filter (14);
a slanted evaporator coil (28) of refrigerator system mounted above the said indoor fan (16);
a second air filter (30) horizontally fixed in the said frame (12) above the said evaporator coil (28);
a chute means for directing inside air to second filter; .
a condenser coil (32) of refrigerator system, open to outside air and insulated to inside space, said condenser coil (32) fixed above said second filter (30) with an out door fan (34) on top for cooling of condenser (32) ; **characterized in that**
the arrangement is such that the suction of the said indoor fan (16) inlet, as per mode of operation, either faces first air filter (14) to enable outside air or towards the second filter (30) to allow from inside air into the space to be cooled.

2. An improved cooling system (10) as claimed in claim 1 wherein the said actuator means (40) is an electronically operated DC Actuator motor driving a rotating arrangement.

3. An improved cooling system (10) as claimed in claims 1 or 2 , wherein said indoor fan (16) is mounted in a fan holding frame (18) having an air inlet cone, pivoted to a pair of distantly and oppositely disposed pivots provided on the vertical strips of panel mounting frame fixed on the said frame structure with said actuator means (40).

4. An improved cooling system (10) as claimed in any of the claims 1 to 3, wherein the panel turning means is an electrically operated mechanism with selection switch to set the axis of the said indoor fan (16) from 0°to 180° for selecting mode of operation either free cooling mode or air conditioning mode.

5. An improved cooling system (10) as claimed in any of the claims 1 to 4, wherein the improved cooling system (10) provides dual path for air movement.

6. An improved cooling system (10) as claimed in any of the previous claims, wherein the said electrical mechanism is a motor (40) operating a gear mechanism (36) with a two position stopper switch to rotate indoor fan through 0° to 180°

7. An improved cooling system (10) as claimed in claim 6, wherein the said turning means is mechanical mechanism operated with lever gear combination means to set axis of the said indoor fan from 0° or 180° for selecting mode of operation either free cooling mode or air conditioning mode.

8. An improved cooling system as claimed in any of the above claims,
wherein the whole improved cooling system with dual airpath and mechanism to change cooling modes is arranged in a combination unit.

9. An improved cooling system as claimed in any of the above claims,
wherein the whole improved cooling system with dual airpath and mechanism to change cooling modes is arranged on a single chassis.
